# EUROPÄISCHE PATENTSCHRIFT

(11) **EP 2 681 296 B1**
(45) Veröffentlichungstag und Bekanntmachung des Hinweises auf die Patenterteilung: **11.04.2018**
(21) Anmeldenummer: 12708517.3
(22) Anmeldetag: 27.02.2012
(51) Int. Cl.: C10L 9/08

(54) **VERFAHREN UND VORRICHTUNG ZUR HYDROTHERMALEN KARBONISIERUNG**
METHOD AND DEVICE FOR HYDROTHERMAL CARBONIZATION
PROCÉDÉ ET DISPOSITIF DE CARBONISATION HYDROTHERMIQUE

(30) Priorität: 04.03.2011 DE 102011001108
(43) Veröffentlichungstag der Anmeldung: 08.01.2014
(73) Patentinhaber: AVA-Co2 Schweiz AG, 6304 Zug (CH)
(72) Erfinder: VYSKOCIL, Jan, CH-6304 Zug (CH); ACHERMANN, Peter, CH-6304 Zug (CH)
(74) Vertreter: Geitz Truckenmüller Lucht Christ
(86) Internationale Anmeldenummer: PCT/EP2012/053250
(87) Internationale Veröffentlichungsnummer: WO 2012/119875

(56) Entgegenhaltungen:
- WO-A1-2010/081191
- WO-A1-2010/092040
- WO-A2-2008/138637
- WO-A2-2010/058377
- DE-A1-102008 026 991
- DE-A1-102008 049 737

## Beschreibung

Die vorliegende Erfindung betrifft ein Verfahren zur hydrothermalen Karbonisierung fester oder flüssiger Biomasse, umfassend die Schritte einer Vorbehandlung der Biomasse in einem Vorheiztank, einer Karbonisierungsreaktion in einem Reaktionstank sowie einer Nachbehandlung der Biomasse in einem Puffertank, wobei im Rahmen der Vorbehandlung zunächst eine diskrete Menge an Biomasse in einen abgeschlossenen Vorheiztank gefördert, dort im Vorheiztank vorbehandelt und der hierbei entstehende Slurry in einen abgeschlossenen Reaktionstank verbracht wird, wo die Karbonisierungsreaktion dieser diskreten, in dem Slurry enthaltenen Menge an Biomasse in dem Reaktionstank ausgelöst wird, wobei der vorbehandelte Slurry mittels einer Slurrypumpe zu dem Reaktionstank gefördert wird, wo der Slurry unter Zugabe von Dampf in den Reaktionstank eingebracht und mit einer Druck- und Temperaturerhöhung beaufschlagt wird, sowie eine hierfür geeignete Vorrichtung.

Ein derartiges Verfahren und eine hierfür geeignete Vorrichtung ergibt sich aus der WO 2010/058377 A2. Aus einem Fest-Flüssig-Gemisch aus Wasser und einer kohlenstoffhaltigen Komponente wird dort eine Temperatur- und Druckbeaufschlagung des Slurry durchgeführt.

Ferner ist aus der DE 10 2008 049 737 A1 bekannt, Kohle aus feuchter Biomasse mittels hydrothermaler Karbonisierung in einem Batch-Betrieb herzustellen.

Die DE 10 2008 026 991 A1 offenbart ferner ein Verfahren zum Herstellen von Kohle, durch hydrothermale Karbonisierung, wobei die Kohlenstoffstrukturen bei Temperaturen von 180 bis 200° C aufgebrochen und gleichzeitig aufkonzentriert werden.

Sodann ist aus der WO 2010/081191 A1 bekannt, unter Druck- und Temperaturzugabe eine Behandlung von in einem wässrigen Slurry enthaltener Kohle vorzunehmen.

Die WO 2010/092040 A1 beschreibt ferner einen hydrothermalen Karbonisierungsprozess, bei dem ein aus Biomasse gewonnenes kohleartiges Material unter Dampfzugabe erhitzt wird um eine aktivierte Biomasse zu erhalten.

Ebenfalls wird verwiesen auf den Offenbarungsgehalt der deutschen Offenlegungsschrift DE 10 2008 028 953 A1. Bei diesem System sind die drei Tanks übereinander angeordnet, wobei der Slurry mithilfe von Wasser aus einem Spülkreislauf einer Wasserspülung von einem Tank in den jeweils darunter gelagerten Tank verbracht werden kann.

Die internationale Patentanmeldung WO 2008/138637 A2 betrifft zwei unterschiedliche Verfahren und Vorrichtungen zur Durchführung einer hydrothermalen Karbonisierungsreaktion, wobei in einem ersten Verfahren die Tanks kontinuierlich durchlaufen werden, während in einem zweiten Verfahren lediglich ein Tank vorhanden ist, welcher gleichzeitig als Vorheiztank, Reaktionstank und Nachbereitungstank verwendet wird. Eine weitere Ein-Tank-Lösung geht zudem aus der DE 10 2009 022 364 hervor.

Ferner ist hierzu beispielhaft die deutsche Patentanmeldung DE 10 2007 022 840 A1 zu nennen, welche ebenfalls zwei der üblichen Verfahren beschreibt. Gemäß dieser Offenbarung ist es sowohl möglich, das hydrothermale Karbonisierungsverfahren als kontinuierliches Verfahren durchzuführen, indem Biomasse zunächst durch einen Vorwärmer geschleust wird, in welchem eine Aufwärmung der Biomasse vor Eintritt in den Hauptreaktor bewirkt wird. Beim Übergang zwischen Vorwärmer und Hauptreaktor ist eine Einrichtung zur Druckerhöhung vorgesehen, mithilfe derer der Reaktionsdruck für den Hauptreaktor aufgebaut wird. Nach einem Durchlaufen des Hauptreaktors verlässt die Biomasse diesen, indem sie einen Druckminderer passiert und schließlich in den so genannten Nachbereiter verbracht wird.

Im Kontrast hierzu offenbart dieselbe Schrift nochmals ein diskontinuierliches Verfahren, bei welchem die Verfahrensschritte der Vorwärmung, die eigentliche Karbonisierungsreaktion und schließlich auch die Nachbereitung in einem gemeinsamen Behälter durchgeführt wird, in welchen zunächst die Biomasse eingefüllt wird und das Produkt, der so genannte "Slurry", nach vollständigem Abschluss der Reaktion entnommen werden kann.

Ein dem grundsätzlich entsprechendes Verfahren ist auch aus der deutschen Patentanmeldung DE 10 2009 015 257 A1 vorbekannt.

Diese vorbekannten hydrothermalen Karbonisierungsverfahren zeichnen sich also im Wesentlichen dadurch aus, dass entweder ein kontinuierliches Verfahren mit ständigem Zu- und Abfluss von Edukt bzw. Produkt stattfindet, oder ein abgeschlossenes Verfahren stattfindet, in welchem in einem einzigen Gesamtschritt eine Entwicklung vom Edukt zum Produkt durchgeführt wird.

Im ersteren Fall stellt sich das Problem, dass ein kontinuierlicher Prozess geschaffen werden muss, in dem extreme Druckerhöhungen und -senkungen realisiert werden müssen. Bei einem kontinuierlichen Verfahren ist dies sehr schwierig, da zwischen den einzelnen Komponenten mehr oder minder fließende Übergänge geschaffen werden müssen. Dies entfällt beim diskontinuierlichen Verfahren, welches im Gegensatz zum kontinuierlichen Verfahren den Nachteil aufweist, dass ein wesentlich geringerer Durchsatz damit erzielt werden kann.

Vor diesem Hintergrund hat es sich als wünschenswert erwiesen, die Vorteile sowohl des kontinuierlichen als auch des diskontinuierlichen Verfahrens miteinander zu kombinieren und gleichzeitig die Nachteile zu beseitigen. Es soll also ein hydrothermales Karbonisierungsverfahren geschaffen werden, welches sowohl zeitsparend und effektiv durchgeführt werden kann, als auch in der Verfahrensführung einfach und kostengünstig durchführbar ist.

Gelöst wird diese Aufgabe durch ein Verfahren zur hydrothermalen Karbonisierung gemäß den Merkmalen des Anspruchs 1 und durch eine Vorrichtung hierfür gemäß den Merkmalen des nebengeordneten Anspruchs 9. Weitere sinnvolle Ausgestaltungen des Verfahrens sowie der Vorrichtung können den jeweiligen Unteransprüchen entnommen werden.

Die grundsätzliche, der Erfindung zu Grunde liegende Idee besteht darin, die Verfahrensschritte der Vorheizung, der eigentlichen Karbonisierungsreaktion und der Nachbehandlung möglichst weitgehend parallel durchzuführen. Aufseiten der Vorrichtung sind hierfür drei separate, abgeschlossene Tanks vorgesehen, nämlich zunächst ein Vorheiztank, in welchem eine Vorbehandlung der Biomasse vorgenommen wird, sodann ein Reaktionstank, in dem die eigentliche Reaktion abläuft, sowie schließlich ein Puffertank, in welchem die Nachbehandlung des Slurry stattfindet. Hierbei sind diese Tanks jeweils so verbunden, dass der Slurry zunächst vom Vorheiztank zum Reaktionstank und von dort aus schließlich zum Puffertank geleitet werden kann.

Aufgrund dieser Anordnung kann zunächst der Vorheiztank mit Biomasse befüllt werden. Nach vollständigem Erwärmen des durch Hinzufügen von Dampf entstehenden Slurry auf die erforderliche Vorheiztemperatur von vorzugsweise etwa 150°C und einer Erhöhung des Drucks auf ca. 5 bar wird der Slurry vollständig aus dem Vorheiztank in den Reaktionstank gefördert. Nach dem Entleeren des Vorheiztanks kann dieser aufs Neue befüllt werden um während des Ablaufens der Karbonisierungsreaktion im Reaktionstank die nächste Charge vorzubereiten.

Nachdem die Vorbehandlung, die eigentliche Reaktion und die Nachbehandlung unterschiedliche Zeitdauern in Anspruch nehmen, erscheint es sinnvoll, unterschiedliche Anzahlen an Vorheiztanks, Reaktionstanks und Puffertanks vorzusehen. So hat es sich beispielsweise als sinnvoll erwiesen, einem Vorheiztank etwa vier bis sechs Reaktionstanks zuzuordnen. Umgekehrt ist einem Puffertank eine Mehrzahl von ca. zwei bis drei Reaktionstanks zugeordnet, so dass eine mögliche Gesamtkonfiguration beispielsweise einen Vorheiztank, sechs Reaktionstanks und zwei Puffertanks umfassen könnte. Die Reaktionstanks sind dabei alternativ von dem Vorheiztank aus beschickbar, während die Puffertanks sowohl alternativ als auch nebeneinander von den Reaktionstanks befüllt werden können. Dies liegt im Wesentlichen daran, dass in den Puffertanks nur eine Nachbehandlung in Form einer Druckminderung und Abkühlung stattfindet, wonach die Entnahme und mögliche Weiterbehandlung des Slurry sich anschließt. Hingegen sollte der Reaktionstank stets mit einer vorbestimmten Menge von Slurry befüllt werden, so dass die Prozessparameter und die Prozessdauer hierauf abgestimmt werden können.

In dem gesamten Verfahren erforderlicher Dampf kann zum einen teilweise aus dem Verfahren selbst zurück gewonnen werden, es steht jedoch zusätzlich ein gemeinsamer, für alle Verfahrensschritte einsetzbarer Dampferzeuger zur Verfügung, welcher den erforderlichen Prozessdampf liefert.

Sowohl der Reaktionstank als auch der Puffertank weist ein Sicherheitsventil auf, über welches ein Entweichen von Dampf bei einem Überschreiten eines kritischen Drucks ermöglicht wird. Das Entweichen des Dampfes erfolgt über einen Schalldämpfer, welcher vorzugsweise dem Puffertank zugeordnet ist.

Das vorbeschriebene Verfahren kann sowohl mit fester als auch mit flüssiger Biomasse durchgeführt werden. Hierfür weist die Vorrichtung zwei separate, angepasste Zuführsysteme auf. Für flüssige Biomasse, welche in einem Zuführtank gelagert und bei Bedarf in den Vorheiztank gefördert wird, ist eine Zuführpumpe vorgesehen, welche über eine Zuführleitung den Vorheiztank beschickt. Soweit feste Biomasse, wie beispielsweise Holz, Gras und andere feste Komponenten zugeführt werden, so werden diese üblicherweise zunächst in einem Silo vorgehalten und bedarfsweise über ein Förderband in einen Zuführtrichter gefördert. Dieser Zuführtrichter mündet in eine Förderschnecke, welche die Biomasse direkt in dem Vorheiztank hinein fördert.

Zur Vorbehandlung der Biomasse bzw. des Slurry kann neben einer Erhitzung und Druckerhöhung im Vorheiztank auch eine weitere Vorbehandlung erfolgen. Ziel der Vorbehandlung ist es grundsätzlich, die in der Biomasse vorhandenen Ligninstrukturen aufzubrechen um die Karbonisierungsreaktion hierdurch zu beschleunigen. Die Ligninstrukturen, die beispielsweise besonders im Holz vorhanden sind, schließen den im Verfahren zu gewinnenden Kohlenstoff ein und sorgen dafür, dass während der Reaktion im Reaktionstank die eigentliche Karbonisierungsreaktion verzögert abläuft. Durch ein geeignetes, vorab stattfindendes Aufbrechen dieser Ligninstrukturen wird die Effizienz des Verfahrens deutlich erhöht.

Hierzu kann, beispielsweise in dem Silo, in welchem die Biomasse in fester Form vorab gelagert wird, eine Beimischung von Enzymen, welche das Aufbrechen der in der Biomasse enthaltenen Ligninstrukturen bewirken, erfolgen. Die so hinzugefügten Enzyme können während der Lagerzeit der Biomasse bereits ihre Wirkung entfalten, so dass die nachfolgenden Schritte zum Aufbrechen der Ligninstrukturen effektiver werden. Es ist darauf zu achten, dass die Enzyme bereits vor der Erwärmung der Biomasse hinzugefügt werden, da diese erhöhte Temperaturen nicht aushalten und daher in einem späteren Verfahrensschritt nicht mehr wirken können.

In einem weiteren Schritt kann die Ligninstruktur weiter vorab aufgebrochen werden, indem, vorzugsweise nach dem Verlassen des Vorheiztanks, der Slurry in einen Druckbehälter eingeleitet wird. In diesem Druckbehälter wird eine so genannte Dampfexplosion ausgelöst, indem eine explosionsartige Druckminderung bewirkt wird. Aufgrund dieser Druckminderung werden die in der Biomasse des Slurry enthaltenen Ligninstrukturen auseinander gerissen, so dass durch diesen Behandlungsschritt erneut eine verbesserte Ausgangsposition für den hierdurch stark verkürzten Karbonisierungsvorgang geschaffen wird.

Der eigentliche Karbonisierungsvorgang läuft dann in dem Reaktionstank ab, in welchen der Slurry unter gleichzeitiger Zugabe von Dampf eingebracht wird. In dem Reaktionstank herrschen vorzugsweise ein Druck von 25 bar und eine Temperatur im Bereich zwischen 210 und 230°C. Während der Karbonisierungsreaktion werden Dampf und Slurry permanent durchmischt um so ein gleichmäßiges Ablaufen der Reaktion in dem gesamten Slurry zu begünstigen. Die Reaktion wird üblicherweise, je nach gewünschtem Produkt, also etwa Braunkohle, Biochar usw., nach einer vorbestimmten Reaktionszeit abgebrochen. Zu diesem Zeitpunkt wird der Reaktionstank in den Puffertank hinein entleert. Dies erfolgt dadurch, dass in dem Puffertank zunächst ein deutlich niedrigerer Druck als im Reaktionstank vorhanden ist, so dass aufgrund des Druckgefälles und der sich öffnenden Rohrleitung der Inhalt des Reaktionstanks in den Puffertank gesaugt wird.

Schließlich wird der hierdurch im Puffertank anliegende Druck nunmehr wiederum sukzessive gesenkt, so dass der Slurry nach einiger Zeit auch aus dem Puffertank entnommen und bedarfsweise zur weiteren Nachbehandlung, etwa in ein Abkühlbecken, gefördert werden kann. Im Zuge der Abkühlung im Puffertank anfallender Prozessdampf kann mit einigem Vorteil dem Reaktionstank wieder zugeführt werden, so dass nicht einerseits mithilfe des Dampferzeugers Dampf bereitgestellt werden und auf der anderen Seite aus dem Puffertank ohne Weiteres entweichen soll. Auch dies erhöht die Effizienz des Verfahrens.

Die vorstehend beschriebene Erfindung wird im Folgenden anhand eines Ausführungsbeispiels näher erläutert.

Es zeigen
- Figur 1: eine Vorrichtung zur hydrothermalen Karbonisierung sowohl fester als auch flüssiger Biomasse in einer perspektivischen Darstellung von schräg oben,
- Figur 2: ein Detail der hydrothermalen Karbonisierungsvorrichtung gemäß Figur 1, betreffend einen Vorheiztank in einer perspektivischen Darstellung von schräg oben,
- Figur 3: ein weiteres Detail der hydrothermalen Karbonisierungsvorrichtung gemäß Figur 1, betreffend einen Reaktionstank in einer perspektivischen Darstellung von schräg oben, sowie
- Figur 4: abermals ein Detail der hydrothermalen Karbonisierungsvorrichtung gemäß Figur 1, betreffend einen Puffertank in einer perspektivischen Darstellung von schräg oben.

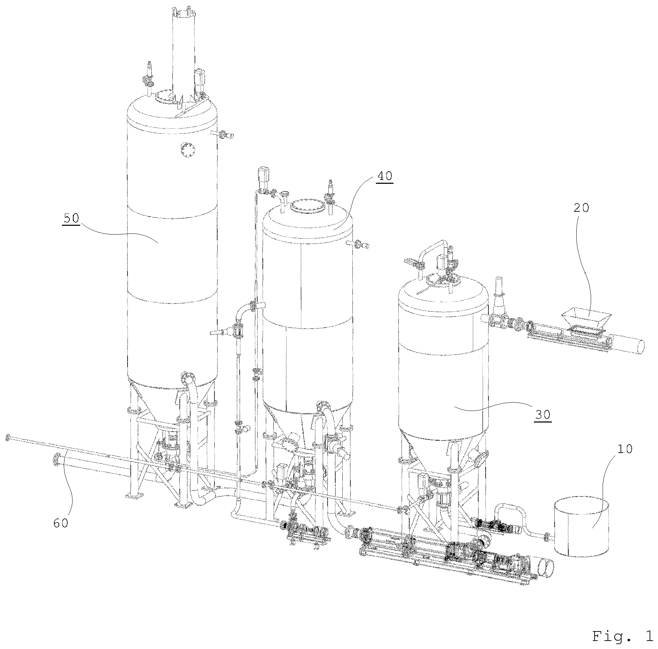

Figur 1 zeigt ein Schema einer Vorrichtung zur hydrothermalen Karbonisierung, welche als so genanntes Multi-Batch-Verfahren ausgelegt ist. Für jeden zu durchlaufenden Prozessschritt ist hier ein eigener Tank 30, 40, 50 vorgesehen, in welchem jeweils ein separater Behandlungsschritt abläuft. So ist zunächst ein Vorheiztank 30 vorhanden, in welchen die zu behandelnde Biomasse entweder aus einem Zuführtank 10 oder über einen Zuführtrichter 20, je nachdem ob es sich um flüssige oder feste Biomasse handelt, zugeführt wird. Nach einem Vorbehandlungsvorgang wird der entstehende Slurry für die eigentliche Karbonisierungsreaktion in den Reaktionstank 40 gefördert. Nach Ablauf der vorgegebenen Reaktionszeit wird der Reaktionstank 40 schließlich in den Puffertank 50 entleert, wo eine Entspannung des Slurry vonstatten geht, und von wo der Slurry schließlich in Richtung eines etwa vorhandenen Abkühlbeckens abgeführt wird, wo er weiterbehandelt, beispielsweise getrocknet werden kann. In den jeweiligen Verfahrensschritten erforderlicher Dampf wird über eine gemeinsame Dampfzuleitung 60 bereitgestellt.

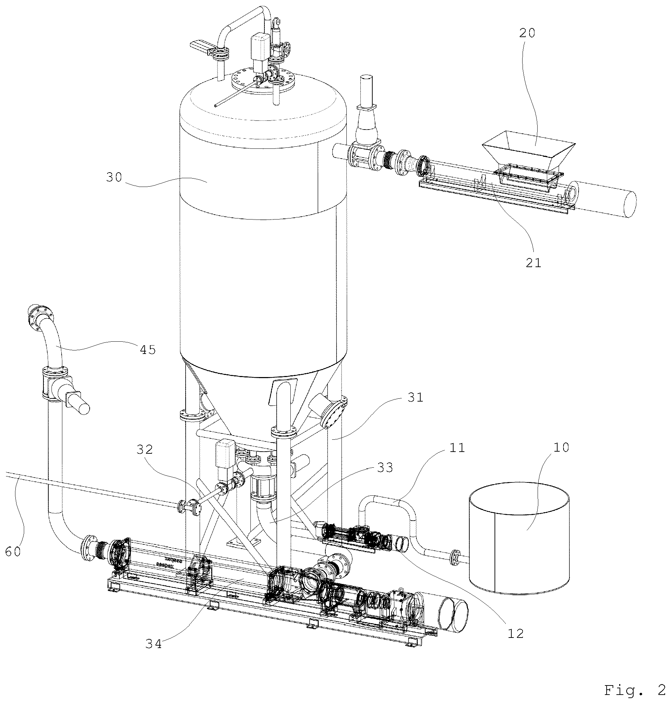

Figur 2 zeigt den Vorheiztank 30, welcher entweder aus einem Zuführtank 10 im Falle von flüssiger Biomasse, oder aber bei fester Biomasse über einen Zuführtrichter 20 beschickt werden kann. In dem Zuführtank 10 gelagerte, flüssige Biomasse wird mithilfe der Zuführpumpe 12 über die Zuführleitung 11 direkt in den Vorheiztank 30 gefördert. Feste Biomasse hingegen wird üblicherweise in einem hier nicht näher dargestellten Silo gelagert und bedarfsweise über ein Förderband hin zum Zuführtrichter 20 verbracht. Der Zuführtrichter 20 mündet in eine Förderschnecke 21, welche in den Zuführtrichter 20 einfallende Biomasse in den Vorheiztank 30 fördert. Die Zuführung der Biomasse erfolgt jeweils von der Oberseite des auf einem Standgerüst 31 aufgeständerten Vorheiztanks 30. Nach einer Druckerhöhung auf ca. 5 bar und einer gleichzeitigen Temperaturerhöhung auf ca. 150°C wird nach Erreichen einer gewünschten Durchmischung des Slurrys dieser über ein Slurryrohr 33 aus dem Vorheiztank 30 entnommen und mithilfe einer Slurrypumpe 34 über ein Slurryzuführrohr 45 zum Reaktionstank 40 gefördert. Die Druck- und Temperaturerhöhung innerhalb des Vorheiztanks 30 erfolgt über zugeleiteten Dampf, welcher über die bereits in Figur 1 gezeigte Dampfzuleitung 60 in den Vorheiztank 30 einströmen kann.

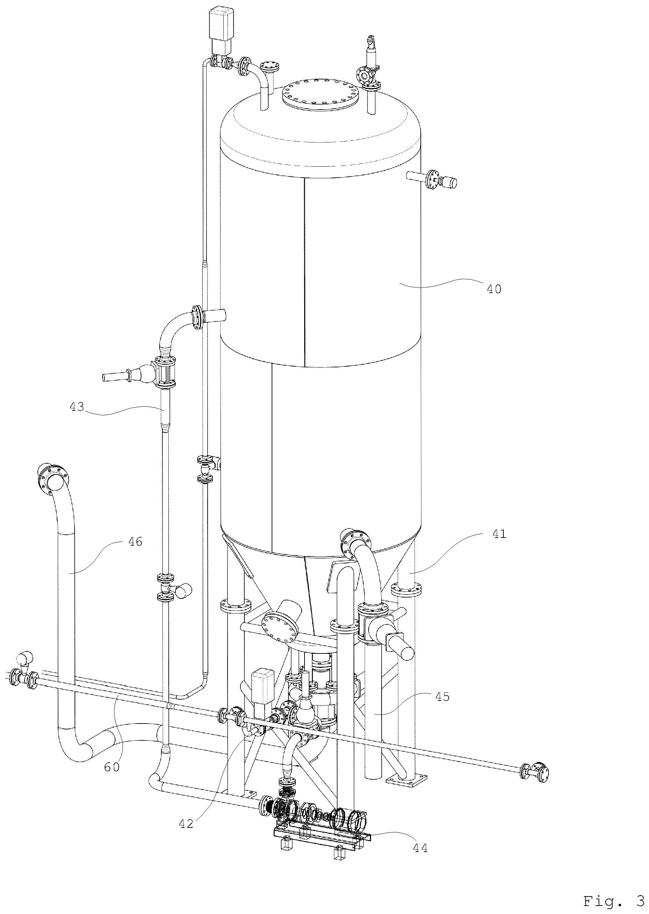

Figur 3 zeigt den Reaktionstank 40, welcher ebenfalls in einer aufrechten Position auf einem Standgerüst 41 gelagert ist. Der über das Slurryzuführrohr 45 in den Reaktionstank 40 geförderte Slurry wird in den Reaktionstank 40 gleichzeitig mit Dampf eingefördert, welcher seinerseits über ein mit der Dampfzuleitung 60 verbundenes Dampfrohr 42 angeliefert wird. Innerhalb des Reaktionstanks 40 findet bei Druckverhältnissen im Bereich von letztlich 25 bar und 210°C bis 230°C die eigentliche Karbonisierungsreaktion statt. Aufgrund einer ständigen Durchmischung des Slurry innerhalb des Reaktionstanks 40 wird eine zügige und gleichmäßige Karbonisierungsreaktion begünstigt. Zur Aufrechterhaltung des Drucks ist eine Mischpumpe 44 vorgesehen, welche zum einen zur Durchmischung des Inhalts des Reaktionstanks 40 beiträgt und zum anderen aus dem Reaktionstank entnommenen Dampf, welcher über ein Zirkulationsrohr 43 angeliefert wird, wieder in den Reaktionstank 40, hineinfördert. Nach Ablauf der Reaktion, insbesondere nach Ablauf einer vorbestimmten Reaktionszeit, wird der Slurry über ein Slurryabführrohr 46 in Richtung des Puffertanks 50 verbracht.

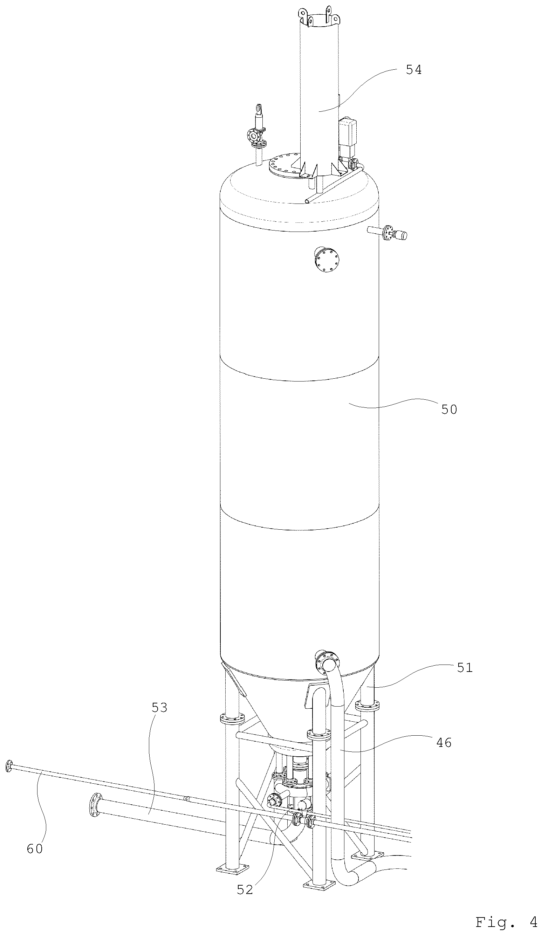

Figur 4 zeigt schließlich den Puffertank 50, in welchen der Slurry über das Slurryabführrohr 46 gefördert wird. Innerhalb des Puffertanks 50 herrscht ein gegenüber dem Druck im Reaktionstank 40 deutlich niedrigerer Druck, so dass bei Öffnen des Slurryabführrohrs 46 der in dem Reaktionstank 40 enthaltene Slurry in den Puffertank 50 gesaugt wird. Auch der Puffertank 50 ist mithilfe eines Standgerüstes 51 in aufrechter Position montiert. Der in dem Puffertank 50 enthaltene Slurry kann sich in dem Puffertank 50 nunmehr entspannen und wird, vorzugsweise nach Erreichen von Atmosphärendruck, dann schließlich über ein Slurryrohr 53 etwa in Richtung eines Abkühlbeckens abgeleitet. In dem Puffertank 50 befindlicher, nicht mehr benötigter Dampf kann einerseits zur Druckminderung über einen Schalldämpfer 54 nach außen abgegeben werden, oder aber zur weiteren Verwendung über das Dampfrohr 52 etwa dem Reaktionstank 40 wieder zugeführt werden.

Vorstehend beschrieben ist somit ein Verfahren zur hydrothermalen Karbonisierung und eine hierzu vorgesehene Vorrichtung, welche im Gegensatz zum Stand der Technik ein Multi-Batch-Verfahren realisieren. Bei diesem ist es vorgesehen, dass sämtliche Verfahrensschritte parallel zueinander in unterschiedlichen Tanks ablaufen, um hierdurch eine hohe Effizienz bei gleichzeitig möglichst einfacher Verfahrensführung realisieren zu können.

### BEZUGSZEICHENLISTE

- 10: Zuführtank
- 11: Zuführleitung
- 12: Zuführpumpe
- 20: Zuführtrichter
- 21: Förderschnecke
- 30: Vorheiztank
- 31: Standgerüst
- 32: Dampfrohr
- 33: Slurryrohr
- 34: Slurrypumpe
- 40: Reaktionstank
- 41: Standgerüst
- 42: Dampfrohr
- 43: Zirkulationsrohr
- 44: Mischpumpe
- 45: Slurryzuführrohr
- 46: Slurryabführrohr
- 50: Puffertank
- 51: Standgerüst
- 52: Dampfrohr
- 53: Slurryrohr
- 54: Schalldämpfer
- 60: Dampfzuleitung

## Patentansprüche

1. Verfahren zur hydrothermalen Karbonisierung fester oder flüssiger Biomasse, umfassend die Schritte einer Vorbehandlung der Biomasse in einem Vorheiztank (30), einer Karbonisierungsreaktion in einem Reaktionstank (40) sowie einer Nachbehandlung der Biomasse in einem Puffertank (50), wobei im Rahmen der Vorbehandlung zunächst eine diskrete Menge an Biomasse in den abgeschlossenen Vorheiztank (30) gefördert, dort im Vorheiztank (30) vorbehandelt und der hierbei entstehende Slurry in einen abgeschlossenen Reaktionstank (40) verbracht wird, wo die Karbonisierungsreaktion dieser diskreten, in dem Slurry enthaltenen Menge an Biomasse in dem Reaktionstank (40) ausgelöst wird, wobei der vorbehandelte Slurry mittels einer Slurrypumpe (34) zu dem Reaktionstank (40) gefördert wird, wo der Slurry unter Zugabe von Dampf in den Reaktionstank (40) eingebracht und mit einer Druck- und Temperaturerhöhung beaufschlagt wird,
**dadurch gekennzeichnet, dass** der vorbehandelte Slurry über ein Slurryzuführrohr (45) unter gleichzeitiger Zugabe von Dampf aus einem Dampferzeuger über ein Dampfrohr (42) in den Reaktionstank (40) eingebracht, mit einer Druck- und Temperaturerhöhung beaufschlagt und im Reaktionstank (40) während des Ablaufs der Karbonisierungsreaktion mithilfe einer Mischpumpe durchmischt wird, wobei der Slurry nach Verlassen des Vorheiztanks (30), jedoch vor seinem Eintritt in den Reaktionstank (40), in einer Druckkammer einer explosionsartigen Druckminderung unterworfen wird.

2. Verfahren gemäß Anspruch 1, **dadurch gekennzeichnet, dass** dem Vorheiztank (30) flüssige Biomasse aus einem Zuführtank (10) mittels einer Zuführpumpe (12) zugeführt wird.

3. Verfahren gemäß einem der Ansprüche 1 oder 2, **dadurch gekennzeichnet, dass** dem Vorheiztank (30) feste Biomasse aus einem Silo, vorzugsweise über ein Förderband und einen Zuführtrichter (20), mittels einer Förderschnecke (21) zugeführt wird.

4. Verfahren gemäß Anspruch 3, **dadurch gekennzeichnet, dass** die in dem Silo gelagerte Biomasse durch Beimischen von Enzymen zum Aufbrechen in der Biomasse enthaltener Ligninstrukturen vorbehandelt wird.

5. Verfahren gemäß einem der vorhergehenden Ansprüche, **dadurch gekennzeichnet, dass** die Biomasse in dem Vorheiztank (30) mit einer Druck- und Temperaturerhöhung, vorzugsweise auf 5 bar und 150°C, beaufschlagt und vorzugsweise hierbei durchmischt wird.

6. Verfahren gemäß einem der vorhergehenden Ansprüche, **dadurch gekennzeichnet, dass** die Karbonisierungsreaktion für eine vorbestimmte Zeit abläuft, wonach der Slurry durch Öffnen eines mit einem Puffertank (50) mit niedrigerem Innendruck verbundenen Slurryabführrohrs (46) aufgrund des Druckgefälles zwischen Reaktionstank (40) und Puffertank (50) in letzteren ausgetragen wird.

7. Verfahren gemäß Anspruch 6, **dadurch gekennzeichnet, dass** der im Puffertank (50) anliegende Druck sukzessive gesenkt und der Slurry vorzugsweise, nach Erreichen von Atmosphärendruck, zur Nachbehandlung in ein Abkühlbecken gefördert wird.

8. Verfahren gemäß einem der Ansprüche 6 oder 7, **dadurch gekennzeichnet, dass** in dem Puffertank (50) anfallender Prozessdampf dem Reaktionstank (40) wieder zugeführt wird.

9. Vorrichtung zur hydrothermalen Karbonisierung fester oder flüssiger Biomasse mit jeweils wenigstens einer Einrichtung zum Vorheizen, einem Reaktor und einer Einrichtung zum Nachbehandeln, wobei als Einrichtung zum Vorheizen wenigstens ein separater, abgeschlossener Vorheiztank (30) vorgesehen ist, welcher mit wenigstens einem separaten, abgeschlossenen, als Reaktor dienenden Reaktionstank (40) verbunden ist, welcher seinerseits in wenigstens einen separaten, abgeschlossenen Puffertank (50) zum Nachbehandeln aus der Biomasse entstehenden Slurrys entleerbar ist, wobei zwischen dem abgeschlossenen Vorheiztank (30) und dem abgeschlossenen Reaktionstank (40) eine Slurrypumpe (34) zum Fördern des Slurry aus dem Vorheiztank (30) in den Reaktionstank (40) angeordnet ist,
**dadurch gekennzeichnet, dass** zur Zuführung von Dampf und Slurry jeweils ein Slurryzuführrohr (45) und ein mit einem Dampferzeuger verbundenes Dampfrohr (42) in den Reaktionstank (40) münden und eine Mischpumpe (44) zur Durchmischung von Dampf und Slurry über eine Zirkulationsleitung mit dem Reaktionstank (40) verbunden ist, wobei zwischen dem abgeschlossenen Vorheiztank (30) und dem abgeschlossenen Reaktionstank (40) eine Druckkammer zur Beaufschlagung des Slurry mit einer explosionsartigen Druckminderung angeordnet ist.

10. Vorrichtung gemäß Anspruch 9, **dadurch gekennzeichnet, dass** mehrere, vorzugsweise vier bis sechs, Reaktionstanks (40) alternativ zueinander von einem gemeinsamen Vorheiztank (30) beschickbar sind.

11. Vorrichtung gemäß einem der Ansprüche 9 oder 10, **dadurch gekennzeichnet, dass** mehrere, vorzugsweise zwei bis drei, Reaktionstanks (40) in einen oder mehrere gemeinsame Puffertanks (50) entleerbar sind.

12. Vorrichtung gemäß einem der Ansprüche 9 bis 11, **dadurch gekennzeichnet, dass** der wenigstens eine Vorheiztank (30), der wenigstens eine Reaktionstank (40) und der wenigstens eine Puffertank (50) mit wenigstens einem, vorzugsweise gemeinsamen, Dampferzeuger zur Bereitstellung erforderlichen Prozessdampfs verbunden sind.

13. Vorrichtung gemäß einem der Ansprüche 9 bis 12, **dadurch gekennzeichnet, dass** dem wenigstens einen Reaktionstank (40) und/oder dem wenigstens einen Puffertank (50) ein Sicherheitsventil zur Drucksenkung, vorzugsweise unter Zwischenschaltung eines Schalldämpfers (54), zugeordnet ist.

## Claims

1. A method for the hydrothermal carbonization of solid or liquid biomass, comprising the steps of a pretreatment of the biomass in a preheating tank (30), a carbonization reaction in a reaction tank (40), and a posttreatment of the biomass in a buffer tank (50), wherein in the scope of the pretreatment, firstly a discrete quantity of biomass is conveyed into the closed preheating tank (30), pretreated therein in the preheating tank (30), and the slurry resulting in this case is moved into a closed reaction tank (40), wherein the carbonization reaction of this discrete quantity of biomass contained in the slurry is triggered in the reaction tank (40), wherein the pretreated slurry is conveyed by means of a slurry pump (34) to the reaction tank (40), where the slurry is introduced into the reaction tank (40) with addition of steam and is subjected to a pressure and temperature increase, **characterized in that** the pretreated slurry is introduced via a slurry supply pipe (45) with simultaneous addition of steam from a steam generator via a steam pipe (42) into the reaction tank (40), is subjected to a pressure and temperature increase, and is thoroughly mixed with the aid of a mixing pump in the reaction tank (40) during the passage of the carbonization reaction, wherein the slurry is subjected to an explosive pressure reduction in a pressure chamber after leaving the preheating tank (30), but before its entry into the reaction tank (40).

2. The method according to Claim 1, **characterized in that** liquid biomass is supplied to the preheating tank (30) from a supply tank (10) by means of a supply pump (12).

3. The method according to any one of Claims 1 or 2, **characterized in that** solid biomass is supplied to the preheating tank (30) from a silo, preferably via a conveyor belt and a supply funnel (20), by means of an auger conveyor (21).

4. The method according to Claim 3, **characterized in that** the biomass stored in the silo is pretreated by admixing enzymes to break up lignin structures contained in the biomass.

5. The method according to any one of the preceding claims, **characterized in that** the biomass is subjected in the preheating tank (30) to a pressure and temperature increase, preferably to 5 bar and 150°C, and is preferably thoroughly mixed in this case.

6. The method according to any one of the preceding claims, **characterized in that** the carbonization reaction runs for a predetermined time, after which the slurry, by way of opening a slurry discharge pipe (46) connected to a buffer tank (50) having lower internal pressure, is discharged into the buffer tank because of the pressure gradient between reaction tank (40) and buffer tank (50).

7. The method according to Claim 6, **characterized in that** the pressure applied in the buffer tank (50) is successively reduced and the slurry is preferably, after reaching atmospheric pressure, conveyed into a cooling basin for posttreatment.

8. The method according to any one of Claims 6 or 7, **characterized in that** process steam arising in the buffer tank (50) is supplied back to the reaction tank (40).

9. A device for the hydrothermal carbonization of solid or liquid biomass having respectively at least one device for preheating, one reactor, and one device for posttreatment, wherein at least one separate, closed preheating tank (30) is provided as the device for preheating, which is connected to at least one separate, closed reaction tank (40) used as a reactor, which in turn can be emptied into at least one separate, closed buffer tank (50) for posttreatment of slurry resulting from the biomass, wherein a slurry pump (34) for conveying the slurry from the preheating tank (30) into the reaction tank (40) is arranged between the closed preheating tank (30) and the closed reaction tank (40),
**characterized in that**, for supplying steam and slurry, respectively a slurry supply pipe (45) and a steam pipe (42) connected to a steam generator open into the reaction tank (40) and a mixing pump (44) for mixing steam and slurry is connected via a circulation line to the reaction tank (40), wherein a pressure chamber for subjecting the slurry to an explosive pressure reduction is arranged between the closed preheating tank (30) and the closed reaction tank (40).

10. The device according to Claim 9, **characterized in that** multiple, preferably four to six, reaction tanks (40) can be charged alternatively to one another by a common preheating tank (30).

11. The device according to any one of Claims 9 or 10, **characterized in that** multiple, preferably 2 to 3 reaction tanks (40) can be emptied into one or multiple common buffer tanks (50).

12. The device according to any one of Claims 9 to 11, **characterized in that** the at least one preheating tank (30), the at least one reaction tank (40), and the at least one buffer tank (50) are connected to at least one, preferably common steam generator for providing required process steam.

13. The device according to any one of Claims 9 to 12, **characterized in that** a safety valve for pressure reduction, preferably with a sound damper (54) interconnected, is associated with the at least one reaction tank (40) and/or the at least one buffer tank (50).

## Revendications

1. Procédé pour la carbonisation hydrothermale de biomasse solide ou liquide, comprenant les étapes de prétraitement de la biomasse dans une cuve de préchauffage (30), de réaction de carbonisation dans une cuve de réaction (40) et de post-traitement de la biomasse dans une cuve tampon (50), dans lequel une quantité discrète de biomasse est d'abord transportée dans la cuve de préchauffage (30) fermée au cours du prétraitement, prétraitée dans la cuve de préchauffage (30), et la boue ainsi produite est amenée dans une cuve de réaction (40) fermée où la réaction de carbonisation de cette quantité de biomasse discrète contenue dans la boue est déclenchée dans la cuve de réaction (40), la boue prétraitée étant acheminée au moyen d'une pompe à boue (34) vers la cuve de réaction (40), introduite en ajoutant de la vapeur dans la cuve de réaction (40) et soumise à une augmentation de la pression et de la température,
**caractérisé en ce que** la boue prétraitée est amenée via un tuyau d'acheminement de boue (45), en ajoutant en même temps de la vapeur provenant d'un générateur de vapeur via un tuyau de vapeur (42), dans la cuve de réaction (40), soumise à une augmentation de la pression et de la température et brassée dans la cuve de réaction (40) pendant le déroulement de la réaction de carbonisation à l'aide d'une pompe de mélange, la boue étant soumise, après être sortie de la cuve de préchauffage (30) mais avant d'entrer dans la cuve de réaction (40), à une réduction explosive de la pression dans une chambre sous pression.

2. Procédé selon la revendication 1, **caractérisé en ce que** de la biomasse liquide est amenée à la cuve de préchauffage (30) à partir d'une cuve d'arrivée (10) au moyen d'une pompe d'arrivée (12).

3. Procédé selon l'une des revendications 1 ou 2, **caractérisé en ce que** de la biomasse solide est amenée à la cuve de préchauffage (30) à partir d'un silo, de préférence par une bande convoyeuse ou un entonnoir d'arrivée (20), au moyen d'un convoyeur à vis sans fin (21).

4. Procédé selon la revendication 3, **caractérisé en ce que** la biomasse stockée dans le silo est prétraitée par l'ajout d'enzymes pour casser les structures de lignine qu'elle contient.

5. Procédé selon l'une des revendications précédentes, **caractérisé en ce que** la biomasse est exposée dans la cuve de préchauffage (30) à une élévation de la pression et de la température, de préférence à 5 bars et 150 °C, et de préférence brassée pendant ce temps.

6. Procédé selon l'une des revendications précédentes, **caractérisé en ce que** la réaction de carbonisation se déroule pendant un certain temps, après quoi la boue est évacuée vers une cuve tampon (50) par l'ouverture d'un tuyau d'évacuation de la boue (46) relié à celle-ci qui se trouve sous une pression plus basse, sous l'effet de la différence de pression entre la cuve de réaction (40) et la cuve tampon (50).

7. Procédé selon la revendication 6, **caractérisé en ce que** la pression régnant dans la cuve tampon (50) est réduite graduellement et la boue est de préférence acheminée vers le post-traitement dans un bassin de refroidissement quand la pression atmosphérique est atteinte.

8. Procédé selon l'une des revendications 6 ou 7, **caractérisé en ce que** la vapeur de process produite dans la cuve tampon (50) est ramenée à la cuve de réaction (40).

9. Dispositif pour la carbonisation hydrothermale de biomasse solide ou liquide, comprenant au moins une installation de préchauffage, un réacteur et une installation de post-traitement, l'installation de préchauffage étant au moins une cuve de préchauffage (30) fermée séparée qui communique avec au moins une cuve de réaction (40) fermée séparée servant de réacteur, qui peut à son tour être vidée dans au moins une cuve tampon (50) fermée séparée pour le post-traitement de la boue issue de la biomasse, dans lequel une pompe à boue (34) est disposée entre la cuve de préchauffage (30) fermée et la cuve de réaction (40) fermée pour acheminer la boue de la cuve de préchauffage (30) à la cuve de réaction (40),
**caractérisé en ce qu'**afin d'amener de la vapeur et de la boue, un tuyau d'arrivée de boue (45) et un tuyau de vapeur (42) communiquant avec un générateur de vapeur débouchent dans la cuve de réaction (40) et une pompe de mélange (44) pour mélanger la vapeur et la boue est reliée par une conduite de circulation à la cuve de réaction (40), une chambre de pression étant disposée entre la cuve de préchauffage (30) fermée et la cuve de réaction (40) fermée pour soumettre la boue à une réduction explosive de la pression.

10. Dispositif selon la revendication 9, **caractérisé en ce que** plusieurs, de préférence entre quatre et six, cuves de réaction (40) peuvent être chargées alternativement par une cuve de préchauffage (30) commune.

11. Dispositif selon l'une des revendications 9 ou 10, **caractérisé en ce que** plusieurs, de préférence entre deux et trois, cuves de réaction (40) peuvent être vidées dans plusieurs cuves tampons (50) communes.

12. Dispositif selon l'une des revendications 9 à 11, **caractérisée en ce que** l'au moins une cuve de préchauffage (30), l'au moins une cuve de réaction (40) et l'au moins une cuve tampon (50) communiquent avec au moins un générateur de vapeur, de préférence commun, destiné à fournir la vapeur de process nécessaire.

13. Dispositif selon l'une des revendications 9 à 12, **caractérisé en ce qu'**une soupape de sécurité est associée à l'au moins une cuve de réaction (40) et/ou à l'au moins une cuve tampon (50) afin de réduire la pression, de préférence en intercalant un silencieux (54).
